# EUROPEAN PATENT APPLICATION

(11) **EP 4 653 839 A1**
(43) Date of publication of application: **26.11.2025**
(21) Application number: 25176318.1
(22) Date of filing: 14.05.2025
(51) Int. Cl.: G01M 13/04

(54) **BEARING FAULT DETECTION**

(30) Priority: 23.05.2024 GB 202407335
(71) Applicant: Rolls-Royce plc, London N1 9FX (GB)
(72) Inventor: Vaiyapuri, Viswanathan, Derby, DE24 8BJ (GB); Nadarajan, Sivakumar, Derby, DE24 8BJ (GB); Gupta, Amit, Derby, DE24 8BJ (GB)
(74) Representative: Rolls-Royce plc

(57) **Abstract**

This disclosure relates to detection of a bearing fault in an electrical propulsion system by shaft voltage measurement. Example embodiments include a method of monitoring an electrical propulsion system (100) comprising a first power electronics converter (102₁) connected between a first DC power source (103₁) and a first AC electric motor (101₁) connected to drive a first shaft (105₁) mounted to a first bearing (106₁), the method comprising: operating the first power electronics converter (102₁) to drive the first AC electric motor (101₁); contacting a first electrical contact (109₁) with the first shaft (105₁); measuring a first voltage between the first electrical contact (109₁) and a first common reference; comparing the first voltage with a predetermined threshold; and determining a fault in the first bearing (106₁) if the measured first voltage exceeds the predetermined threshold.

## Description

### CROSS REFERENCE TO RELATED APPLICATIONS

This represents the first application directed towards the subject-matter.

### FIELD

This disclosure relates to detection of a bearing fault in an electrical propulsion system by shaft voltage measurement.

### BACKGROUND

High power density power electronics converters are important components of power and propulsion systems for electric vertical take-off and landing (eVTOL) aircraft, hybrid electric aircraft and more generally aircraft having increasing levels of electric power systems, known commonly as 'more electric aircraft'.

It is important to ensure the reliability and availability of the electrical assets in so-called multi-lane systems, in which more than one electric motor is used, each electric motor being driven by a respective power electronics converter. In applications such as UAM (urban air mobility) and eVTOL, identical high power density propulsion motors may be used in each lane in a multi-lane system. Permanent magnet electrical machines may be used for aerospace applications due to their high power density and reliability. However, faults in or around the electrical machine may lead to significant damage to the machine and the associated system. Detection of such faults, ideally in advance of any failure, is therefore a general aim.

A bearing is commonly used to support the rotating shaft of a propulsion motor. Bearings may be considered critical components in an electrical aircraft because bearing faults can constitute a significant portion of propulsion motor faults and therefore be a key reason for downtime of electric aircraft. Thus, an accurate detection of a bearing fault at an incipient stage would be advantageous to allow for condition-based maintenance and to ensure secure and reliable operation of propulsion motors and reduce any potential loss of revenue due to unscheduled downtime.

### SUMMARY

According to a first aspect there is provided a method of monitoring an electrical propulsion system comprising a first power electronics converter connected between a first DC power source and a first AC electric motor connected to drive a first shaft mounted to a first bearing, the method comprising:
operating the first power electronics converter to drive the first AC electric motor;
contacting a first electrical contact with the first shaft;
measuring a first voltage between the first electrical contact and a first common reference;
comparing the first voltage with a predetermined threshold; and
determining a fault in the first bearing if the measured first voltage exceeds the predetermined threshold.

The electrical propulsion system may comprise a second power electronics converter connected between a second DC power source and a second AC electric motor connected to drive a second shaft mounted to a second bearing, wherein the method further comprises:
operating the second power electronics converter to drive the second electric motor;
contacting a second electrical contact with the second shaft;
measuring a second voltage between the second electrical contact on the second shaft and a second common reference; and
determining a fault in the second bearing if the measured second voltage exceeds the predetermined threshold.

The predetermined threshold may be defined by a ratio between the first and second voltages.

A fault may be determined in the first bearing if the ratio is above a first predetermined threshold and in the second bearing if the ratio is below a second predetermined threshold.

The first predetermined threshold may be above 1 and the second predetermined threshold below 1.

The step of contacting the electrical contact may comprise operating an actuator to move the electrical contact towards the shaft.

According to a second aspect there is provided a system for monitoring an electrical propulsion system comprising a first power electronics converter connected between a first DC power source and a first AC electric motor connected to drive a first shaft mounted to a first bearing, the system comprising:
a first voltage sensor having a first electrical contact arranged to contact the first shaft and arranged to measure a first voltage between the first electrical contact and a first common reference; and
a monitoring unit configured to:
   receive the first voltage measurement;
   compare the first voltage with a predetermined threshold; and
   determine a fault in the first bearing if the first voltage exceeds the predetermined threshold.

The electrical propulsion system may comprise a second power electronics converter connected between a second DC power source and a second AC electric motor connected to drive a second shaft mounted to a second bearing, the system further comprising a second voltage sensor having a second electrical contact arranged to contact the second shaft and arranged to measure a second voltage between the second electrical contact and a second common reference, wherein the monitoring unit is further configured to:
receive the second voltage measurement;
compare the second voltage with the predetermined threshold; and
determine a fault in the second bearing if the second voltage exceeds the predetermined threshold.

The predetermined threshold may be defined by a ratio between the first and second voltages.

The monitoring unit may be configured to determine a fault in the first bearing if the ratio is above a first predetermined threshold and in the second bearing if the ratio is below a second predetermined threshold.

The first predetermined threshold may be above 1 and the second predetermined threshold below 1.

The first voltage sensor may comprise:
an actuator having a movable arm on which the electrical contact is mounted;
a control module connected to the actuator and configured to:
   operate the actuator to contact the electrical contact with the first shaft;
   measure the first voltage between the first electrical contact and the first common reference; and
   transmit the measured first voltage to the monitoring unit.

The common reference may be a connection to a casing of the first electric motor.

The control module may be configured to transmit the measured first voltage wirelessly to the monitoring unit.

According to a third aspect there is provided an electric propulsion system comprising:
a first DC power source;
a first AC electric motor connected to drive a first shaft mounted to a first bearing;
a first power electronics converter connected between the first DC power source and the first AC electric motor; and
a system according to the second aspect.

### BRIEF DESCRIPTION OF THE DRAWINGS

Embodiments will now be described by way of example only with reference to the accompanying drawings, in which:
Figure 1 is a schematic diagram of an example electric propulsion system comprising a bearing fault monitoring system;
Figure 2 is a schematic diagram of an example electrical machine with a shaft voltage sensor;
Figure 3 is a schematic diagram of an example electrical propulsion system incorporating a bearing fault detection system;
Figure 4 is a flow diagram illustrating an example method of monitoring an electrical propulsion system; and
Figure 5 is a flow diagram illustrating an example method of monitoring a multi-lane electrical propulsion system.

### DETAILED DESCRIPTION

In an electric propulsion motor, a voltage may be generated on a drive shaft due to the fast high power switching operations of an inverter driving operation of the motor. High speed switching of PWM inverters driving variable frequency electric motors tend to induce capacitively coupled shaft voltages in the electric motor. The high frequency switching speed of transistors, typically IGBTs, used in such inverters tend to produce a common mode voltage on the motor shaft during normal operation through parasitic capacitance between the stator and the rotor. Once this voltage reaches a level sufficient to overcome the dielectric breakdown strength of the bearing grease, an arc passes through the motor bearing, discharging to the motor housing. If the shaft voltage is high enough, typically between 10 and 40 V, the resulting discharge can create pitting in the motor bearing through a process similar to electrical discharge machining. This damages the bearing and will eventually lead to bearing failure. Higher shaft voltages tend to lead to more arcing, which causes damage and premature failure of a bearing on which the drive shaft is mounted. Measuring the shaft voltage can therefore provide an indication of potential bearing failure.

Described herein is a bearing fault monitoring system in which a voltage difference between a motor shaft and a common reference is measured and a condition of the bearing determined from this measurement. Detection of a bearing fault allows for maintenance to be scheduled or other actions to be taken to prevent consequential damage, thereby reducing unscheduled downtime and prolonging the life of the propulsion system.

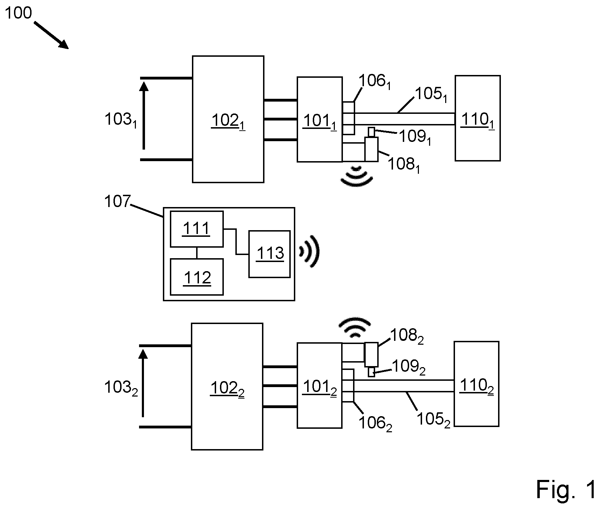

Figure 1 illustrates in schematic form an example electrical power system 100, which may for example comprise a propulsion system for an electric or hybrid electric aircraft. The system 100 comprises first and second electric machines 101₁, 101₂ driven as electric motors by respective first and second power electronics converters 102₁, 102₂, which in this example operate as inverters to convert respective first and second DC supplies 103₁, 103₂ to a three-phase AC output supply to the first and second electric machines 101₁, 101₂. The first and second electrical machines 101₁, 101₂ may be nominally identical. Each electrical machine 101₁, 101₂ is connected to a respective shaft 105₁, 105₂ mounted on a respective bearing 106₁, 106₂.

Each electric machine 101₁, 101₂ drives a respective mechanical load 110₁, 110₂, which may for example be a propulsor, i.e. a propellor or fan. The electric machines 101₁, 101₂ may alternatively drive a common shaft that drives a common propulsor.

In some implementations the system 100 may comprise only one electric machine and associated components. In other implementations the two electric machines 101₁, 101₂ may operate together to drive a common mechanical load.

A first voltage sensor 108₁ comprises a first electrical contact 109₁ that is arranged to contact the first shaft 105₁. The first voltage sensor 108₁ is arranged to measure a first voltage between the first electrical contact 109₁ and a first common reference. The first common reference may for example be an electrical connection to a casing of the first electric motor 101₁.

A second voltage sensor 108₂ comprises a second electrical contact 109₂ that is arranged to contact the second shaft 105₂. The second voltage sensor 108₂ is arranged to measure a second voltage between the second electrical contact 109₂ and a second common reference. The second common reference may for example be an electrical connection to a casing of the second electric motor 101₂. The first and second common references may be connected to each other with a common ground connection or may be part of separate isolated electrical systems.

A monitoring unit 107 is configured to receive voltage measurements from the first and second voltage sensors 108₁, 108₂. The voltage measurements, together with control signals from the monitoring unit 107, may be transmitted wirelessly as illustrated in Figure 1 or may alternatively be transmitted by wired connections between each voltage sensor 108₁, 108₂ and the monitoring unit 107. The monitoring unit 107 may comprise a general purpose computer having a processor 111, memory 112 and input/output (I/O) interface 113. The I/O interface receives signals from the voltage sensors 108₁, 108₂ and transmits control signals from the processor 111 to the voltage sensors 108₁, 108₂. The processor 111 operates according to instructions stored on the memory 112 and stores received voltage measurements in the memory for processing.

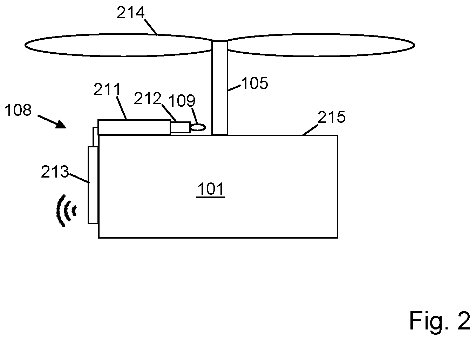

Figure 2 illustrates an example shaft voltage sensor 108 mounted to an electric machine 101, which may apply to either or both voltage sensors 108₁, 108₂ and electric machines 101₁, 101₂ in the example illustrated in Figure 1. The voltage sensor 108 comprises an actuator 211 having a movable arm 212 on which an electrical contact 109 is mounted. The electrical contact 109 may for example comprise a carbon brush. The actuator 211 may for example be a linear actuator arranged to translate the arm 212 and electrical contact 109 radially towards the shaft 105 to make electrical contact with the shaft 105. A control module 213 is connected to the actuator 211 and is configured to operate the actuator 211 to contact the electrical contact 109 with the shaft 105. Once the electrical contact 109 is in contact with the shaft 105, the control module 213 measures a voltage between the electrical contact 109 and a common reference, which may be an electrical contact to a casing 215 of the electric machine 101. The control module 213 then transmits the measured voltage to the monitoring unit 107 either wirelessly or via a wired connection.

In some implementations, the shaft may be connected to ground to short any generated voltage on the shaft 105. In such implementations, instead of an actuator 211 an electronically activated swich can be used to connect between the shaft 105 and the common reference or ground connection. The electronically activated switch can be opened whenever a voltage measurement is required. In either case, the electric actuator 211 or electronic switch is controlled by the monitoring unit 107. The monitoring unit 107 may be part of a portable **EHM** unit that is operated by aircraft inspection or maintenance personnel to measure the bearing voltage as part of a startup-check, on-wing maintenance or inspection or during service. The measured bearing voltage may for example be wirelessly transmitted to the portable **EHM** unit for the detection bearing failure before a prestart check of an electric aircraft or during an on-wing inspection or during service.

Any changes in the measured shaft voltage are captured and assessed by the monitoring unit 107. Any observed variations can be processed by the monitoring unit 107 to determine the heath status of the bearing. In some implementations, the proposed arrangement can be used to measure a bearing voltage on the other side of identical motors sharing a common shaft.

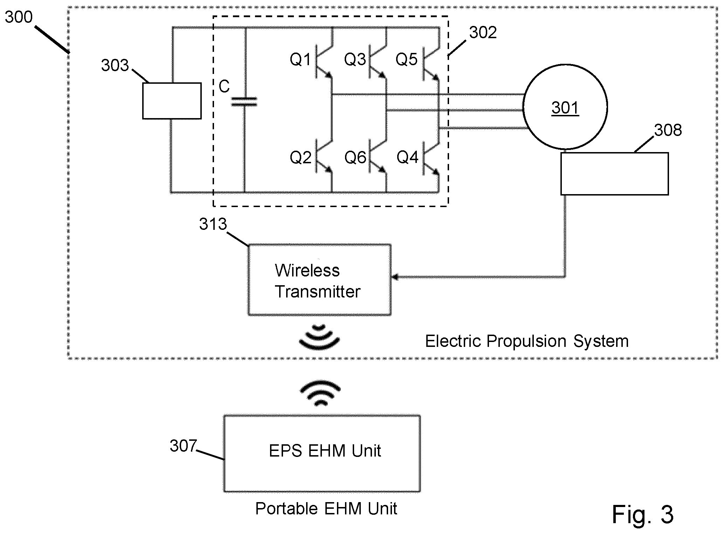

Figure 3 illustrates schematically an electric propulsion system in communication with a portable EHM (engine health monitoring) unit 307. The portable EHM unit 307 may have similar features to those of the monitoring unit 107 described above in relation to Figure 1. The EHM unit 307 is in wireless communication with a transmitter 313 of a voltage sensor 308 of a three phase AC electric motor 301. The voltage sensor 308 may comprise features of the voltage sensor 108 described above in relation to Figure 2. The motor 301 is driven by a three phase AC output supply provided by a power electronics converter 302, which is provided with a DC power supply 303. The converter 302 is operated under control of a controller (not shown), which provides switching signals to each of the switches Q1-Q6 to drive the output of the converter 302. When a voltage measurement is required, the EHM unit 307 signals to the wireless transmitter 313 to operate the voltage sensor 308 to make contact with the shaft of the motor 301, either by actuating a moveable contact or switching out a bypass connection as described above. A voltage measurement is then returned wirelessly to the EHM unit 307 and a determination made by the EHM unit 307 as to whether there may be a bearing fault.

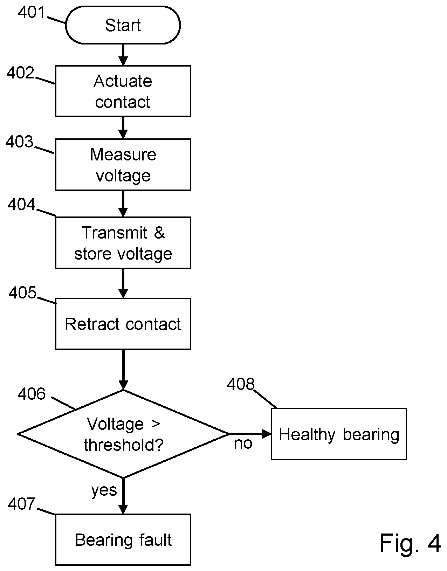

Figure 4 is a flow diagram illustrating an example method of monitoring an electrical propulsion system of the type described above. The method starts at step 401 with the electric motor being operated. The level of load applied for the method may be light compared to a rated load, for example less than 25% or less than 10% of the motor's rated load. At step 402, a signal is sent from the EHM unit to the voltage sensor to make electrical contact with the shaft. As described above, this may be done by operating an actuator to move an electrical contact towards the shaft or may be done by operating a switch to open a shorted connection to the shaft. The electrical contact may be made for a specified time period while a voltage measurement is taken at step 403. The measured shaft voltage is then transmitted to the EHM unit and stored at step 404, after which the electrical contact can be removed at step 405, for example by sending a signal to the actuator controller to retract the actuator arm from the motor shaft once the voltage measurement is complete. The EHM unit then, at step 406, compares the measured voltage against a predetermined threshold and determined whether the measured voltage is above this threshold. If the measured voltage is above the threshold, at step 407 a bearing fault is indicated. Otherwise, at step 408, a healthy bearing is indicated.

As indicated in the example system 100 of Figure 1, the above method can be extended to electrical machines in multiple lanes. A health index may be formulated based on a measured peak shaft voltage ratio and checked against a measured voltage in each lane. If the measured voltage for a lane is greater than this threshold, this indicates that a bearing fault has developed in that lane.

An advantage of the approach described herein is that the amplitude and accuracy of fault detection can be higher than conventional approaches. The methods described herein can also predict bearing faults in different lanes of a multiple lane system, which can assist in timely maintenance and repair or replacement activities.

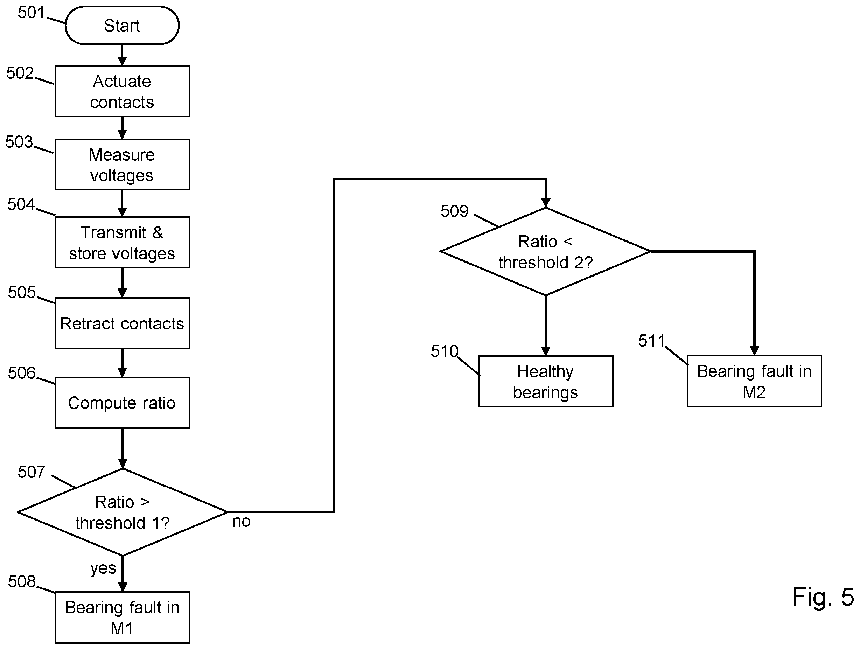

Figure 5 illustrates an example flow diagram of a method of monitoring an electrical propulsion system having multiple electric motors, for example first and second electric motors as described above in relation to the example in Figure 1. In a first step 501, both motors 101₁, 101₂ are operated at a light load. A signal is then sent at step 502 from the monitoring unit 107 to the control module of each voltage sensor 108₁, 108₂ to make electrical contact with the respective shaft 105₁, 105₂, for example by operating an actuator to move an electrical contact to the shaft. A shaft voltage is then measured for each electric motor at step 503 and the voltage measurements transmitted to the monitoring unit 107 and stored at step 504. A signal is then sent to each voltage sensor 108₁, 108₂ at step 505 to break electrical contact with the respective shafts 105₁, 105₂, for example by retracting the actuator arms. At step 506, a ratio is computed of the measured peak shaft voltages from the electric motors 101₁, 101₂. At step 508, a comparison is made of the ratio relative to a first threshold. If the ratio is greater than the first threshold then, at step 508, a bearing fault is determined in the first electric motor 101₁. Otherwise, a check is made at step 509 as to whether the ratio is less than a second threshold. If the ratio is less than the second threshold, a bearing fault is detected in the second electric motor 101₂ at step 511. Otherwise, the bearings are determined to be healthy at step 510. The first and second thresholds may be preset to be either side of 1, for example 1.1 and 0.9, so that variability in the measured voltages between the shafts can be accounted for without making false detections.

The methods and systems described herein could be used to assess the status of the bearing health of an aircraft propulsion system before take-off, which can enhance safety of the electric aircraft.

The methods and system described herein provides an approach to detecting early-stage bearing faults in electrical machines based on shaft voltage measurement. The techniques can be applied to any type of electrical asset for example PM (permanent magnet) machines, induction machines, wound field synchronous machines, and may apply to multiple phase machines including for example six or twelve phase machines that are designed for UAM or CAP respectively.

The measured shaft voltages can be compared between lanes to assess degradation and potential faults in each lane. An advantage is that this technique does not require any specific threshold definition, as the technique makes use of other lane data as a threshold.

Making the monitoring unit portable can eliminate the need for bearing health monitoring units in the aircraft, which reduces the certification demand and weight of the electric aircraft.

A further advantage is that maintenance can be scheduled in time or other actions to be taken to prevent consequential damages of power and propulsion system. The method can therefore reduce electrical propulsion system downtime, saving cost and prolonging the life of the power and propulsion system.

Various examples have been described, each of which comprise one or more combinations of features. It will be appreciated by those skilled in the art that, except where clearly mutually exclusive, any of the features may be employed separately or in combination with any other features and the invention extends to and includes all combinations and sub-combinations of one or more features described herein.

## Claims

1. A method of monitoring an electrical propulsion system (100) comprising a first power electronics converter (102₁) connected between a first DC power source (103₁) and a first AC electric motor (101₁) connected to drive a first shaft (105₁) mounted to a first bearing (106₁), the method comprising:
operating the first power electronics converter (102₁) to drive the first AC electric motor (101₁);
contacting a first electrical contact (109₁) with the first shaft (105₁);
measuring a first voltage between the first electrical contact (109₁) and a first common reference;
comparing the first voltage with a predetermined threshold; and
determining a fault in the first bearing (106₁) if the measured first voltage exceeds the predetermined threshold.

2. The method of claim 1, wherein the electrical propulsion system (100) comprises a second power electronics converter (102₂) connected between a second DC power source (103₂) and a second AC electric motor (101₂) connected to drive a second shaft (105₂) mounted to a second bearing (106₂), wherein the method further comprises:
operating the second power electronics converter (102₂) to drive the second electric motor (101₂);
contacting a second electrical contact (109₂) with the second shaft (105₂);
measuring a second voltage between the second electrical contact (109₂) on the second shaft (105₂) and a second common reference; and
determining a fault in the second bearing (106₂) if the measured second voltage exceeds the predetermined threshold.

3. The method of claim 2 wherein the predetermined threshold is defined by a ratio between the first and second voltages.

4. The method of claim 3, wherein a fault is determined in the first bearing (106₁) if the ratio is above a first predetermined threshold and in the second bearing (106₂) if the ratio is below a second predetermined threshold.

5. The method of claim 4, wherein the first predetermined threshold is above 1 and the second predetermined threshold is below 1.

6. The method of any preceding claim, wherein the step of contacting the electrical contact (109₁, 109₂) comprises operating an actuator (108₁, 108₂) to move the electrical contact towards the shaft (105₁, 105₂).

7. A system for monitoring an electrical propulsion system (100) comprising a first power electronics converter (102₁) connected between a first DC power source (103₁) and a first AC electric motor (101₁) connected to drive a first shaft (105₁) mounted to a first bearing (106₁), the system comprising:
a first voltage sensor (108₁) having a first electrical contact (109₁) arranged to contact the first shaft (105₁) and arranged to measure a first voltage between the first electrical contact (109₁) and a first common reference; and
a monitoring unit (107) configured to:
receive the first voltage measurement;
compare the first voltage with a predetermined threshold; and
determine a fault in the first bearing (106₁) if the first voltage exceeds the predetermined threshold.

8. The system of claim 7, wherein the electrical propulsion system (100) comprises a second power electronics converter (102₂) connected between a second DC power source (103₂) and a second AC electric motor (101₂) connected to drive a second shaft (105₂) mounted to a second bearing (106₂), the system further comprising a second voltage sensor (108₂) having a second electrical contact (109₂) arranged to contact the second shaft (105₂) and arranged to measure a second voltage between the second electrical contact (109₂) and a second common reference, wherein the monitoring unit (107) is further configured to:
receive the second voltage measurement;
compare the second voltage with the predetermined threshold; and
determine a fault in the second bearing (106₂) if the second voltage exceeds the predetermined threshold.

9. The system of claim 8, wherein the predetermined threshold is defined by a ratio between the first and second voltages.

10. The system of claim 9, wherein the monitoring unit (107) is configured to determine a fault in the first bearing (106₁) if the ratio is above a first predetermined threshold and in the second bearing (106₂) if the ratio is below a second predetermined threshold.

11. The system of claim 10, wherein the first predetermined threshold is above 1 and the second predetermined threshold is below 1.

12. The system of any one of claims 7 to 11, wherein the first voltage sensor (108) comprises:
an actuator (211) having a movable arm (212) on which the electrical contact (109) is mounted;
a control module (213) connected to the actuator (211) and configured to:
operate the actuator (211) to contact the electrical contact with the first shaft (105);
measure the first voltage between the first electrical contact (109) and the first common reference; and
transmit the measured first voltage to the monitoring unit (107).

13. The system of any one of claims 7 to 12, wherein the common reference is a connection to a casing (215) of the first electric motor (101).

14. The system of any one of claims 7 to 13, wherein the control module (213) is configured to transmit the measured first voltage wirelessly to the monitoring unit (107).

15. An electric propulsion system (100, 300) comprising:
a first DC power source (103₁);
a first AC electric motor (101₁) connected to drive a first shaft (105₁) mounted to a first bearing (106₁);
a first power electronics converter (102₁) connected between the first DC power source (103₁) and the first AC electric motor (101₁); and
a system according to any one of claims 7 to 14.
